# EUROPEAN PATENT SPECIFICATION

(11) **EP 4 322 719 B1**
(45) Date of publication and mention of the grant of the patent: **01.07.2026**
(21) Application number: 22200179.4
(22) Date of filing: 07.10.2022
(51) Int. Cl.: H05K 7/20

(54) **TWO-PHASE IMMERSION-COOLING SYSTEM AND VAPOR PRESSURE CONTROLLING METHOD FOR CONTROLLING TWO-PHASE IMMERSION-COOLING SYSTEM**
ZWEIPHASIGES TAUCHKÜHLSYSTEM UND DAMPFDRUCKSTEUERUNGSVERFAHREN ZUR STEUERUNG DES ZWEIPHASIGEN TAUCHKÜHLSYSTEMS
SYSTÈME DE REFROIDISSEMENT PAR IMMERSION À DEUX PHASES ET PROCÉDÉ DE COMMANDE DE PRESSION DE VAPEUR POUR COMMANDER UN SYSTÈME DE REFROIDISSEMENT PAR IMMERSION À DEUX PHASES

(30) Priority: 12.08.2022 TW 111130357
(43) Date of publication of application: 14.02.2024
(73) Proprietor: Giga Computing Technology Co., Ltd., New Taipei City 231 (TW)
(72) Inventor: LIN, JIAN-HUNG, New Taipei City (TW); HUANG, Ching-Chuan, New Taipei City (TW); ADACHI, NOBUHIRO, New Taipei City (TW)
(74) Representative: dompatent

(56) References cited:
- WO-A1-2022/022863
- US-A1- 2018 020 573
- US-A1- 2020 052 356
- US-A1- 2020 158 443
- US-A1- 2022 256 744

## Description

### Technical Field

The disclosure relates to a cooling system, more particularly relates to a two-phase immersion-cooling system and a vapor pressure controlling method for controlling a two-phase immersion-cooling system.

### Background

With the rapid growth of technology, especially in the era that has large demand in internet, artificial intelligence, and cloud services, the data centers constantly need to process a massive amount of data. In order to maintain or improve the efficiency of the data centers. It is necessary to continuously and effectively remove heat generated by the data centers. Thus, in recent years, liquid-cooling technologies, such as immersion cooling have gradually gained attention.

Specifically, immersion cooling has a contain capable of accommodating two-phase coolant and heat sources (e.g., mainboard and electrical elements thereon), the two-phase coolant is a dielectric coolant and therefore can have a thoroughly thermal contact with the heat sources, such that the immersion cooling is much more efficient than air cooling in terms of heat dissipation. The two-phase coolant will evaporate and change to gas form, the gas-phase coolant flows upwards and can be condensed into liquid form by one or more condensers and then fall back to the coolant pool of the condenser.

When the gas-phase coolant is continuously created, the internal pressure of the container is kept increasing. The excessive increase of the internal pressure would cause damage to the container and thereby resulting in coolant leakage. And the increase of the pressure difference between the internal of the container and the outside further increases the speed of leakage flow. These problems not only affects the overall heat dissipation efficiency but also increase the cost due to replenishment of lost coolant.

A conventional means, that adopts an inflatable chamber connected to the top of the container, is used to attempt to solve the aforementioned problem. The inflatable chamber inflates as the pressure of the container increases so as to trying to reduce the possibility of damage and leakage due to excessive high internal pressure. However, it is known that such a conventional means is still not effective in preventing the aforementioned problems.

US 2020/0052356 A1 discloses a system for thermal regulation of an energy storage device.

US 2018/0020573 A1 discloses a refrigeration system for electronics.

US 2022/0256744 A1 discloses a two-phase immersion cooling system with a usable warmed liquid output.

US 2020/0158443 A1 discloses a cooling device with a pressure adjuster.

WO 2022/022863 A1 discloses a two-phase immersion cooling apparatus with an active vapor management.

### SUMMARY

Accordingly, one aspect of the disclosure is to provide a two-phase immersion-cooling system and a vapor pressure controlling method which are capable of effectively preventing damage to container due to high pressure and leakage due to pressure difference.

The disclosure provides a two-phase immersion-cooling system, not according to the invention, adapted for accommodating and cooling at least one heat source, including a container, a pressure vessel, and a vapor compressor, the container includes a liquid-storing area and a vapor area, the liquid-storing area is configured for accommodating the at least one heat source and a liquid-phase coolant, the liquid-phase coolant is configured for in thermal contact with the at least one heat source and to be vaporized into a gas-phase coolant towards the vapor area and mixed with an air and a water vapor in the vapor area into a mixed gas. The pressure vessel is connected to the vapor area of the container via a gas channel, the vapor compressor is disposed on the gas channel and configured to draw the mixed gas in the vapor area of the container so as to decrease pressure of the vapor area and to inject the mixed gas into the pressure vessel so as to increase pressure of the pressure vessel.

The invention provides a vapor pressure controlling method according to claim 1.

According to the two-phase immersion-cooling system and the vapor pressure controlling method as discussed above, since the vapor compressor is able to draw the gas substance from the container and inject it to the pressure vessel, the internal pressure of the container can be prevented from being too high to cause damage to the container, and leakage due to high pressure difference between the internal of the container and the outside is effectively prevented.

Also, the air and water vapor in the vapor area of the container can be selectively moved to the pressure vessel, thus the proportion of the gas-phase coolant in the vapor area of the container can be increased. As such, under the same total pressure, the partial pressure of the gas-phase coolant in the container will be increased, thus the condensable temperature of the gas-phase coolant in the container can be increased, such that the condenser being arranged in the vapor area of the container is able to effectively condense the gas-phase coolant only using a coolant in relatively high temperature and less flowrate, thus, the loading and power-consumption of the condenser are significantly reduced.

In addition, the gas-phase coolant is pressurized and pumped to the pressure vessel from the container, the internal pressure of the pressure vessel may reach a level that makes the gas-phase coolant from the container condensed easier but keeps the air remaining in gas form, thus air and water vapor will be remaining in the gas-collecting area of the pressure vessel and the gas-phase coolant will be condensed and falling to the liquid-collecting area of the pressure vessel, thereby preventing loss of the two-phase coolant during heat dissipation.

### BRIEF DESCRIPTION OF THE DRAWINGS

The present disclosure will become better understood from the detailed description given hereinbelow and the accompanying drawings which are given by way of illustration only and thus are not intending to limit the present disclosure and wherein:
FIG. 1 is a schematic view of a two-phase immersion-cooling system according to one embodiment of the disclosure;
FIG. 2 is an enlarged view of a pressure vessel of the two-phase immersion-cooling system in FIG. 1;
FIG. 3 depicts a circuit diagram of a two-phase immersion-cooling system according to one embodiment of the disclosure; and
FIGS. 4-6 are flowcharts of a vapor pressure controlling method for controlling a two-phase immersion-cooling system.

### DETAILED DESCRIPTION

Aspects and advantages of the disclosure will become apparent from the following detailed descriptions with the accompanying drawings. The inclusion of such details provides a thorough understanding of the disclosure sufficient to enable one skilled in the art to practice the described embodiments but it is for the purpose of illustration only and should not be understood to limit the disclosure.

It is to be understood that the phraseology and terminology used herein are for the purpose of better understanding the descriptions and should not be regarded as limiting. As used herein, the terms "substantially" or "approximately" may describe a slight deviation from a target value, in particular a deviation within the production accuracy and/or within the necessary accuracy, so that an effect as present with the target value is maintained. Unless specified or limited otherwise, the phrase "at least one" as used herein may mean that the quantity of the described element or component is one or more than one but does not necessarily mean that the quantity is only one. The term "and/or" may be used herein to indicate that either or both of two stated possibilities. Unless specified or limited otherwise, the terms "mounted", "connected", "disposed", "fixed", and variations thereof are used broadly and encompass both direct and indirect mounting, connection, disposing, and fixing.

The terms "pathway", "passage", "pipe", "channel", and "tube" used herein may be referred to an object or an assembly of one or more components that can transfer fluid (e.g., air, water, water vapor, liquid-phase coolant, and/or gas-phase coolant) to flow therewithin. The phrase "in fluid communication with" used herein means a situation that fluid (liquid and/or gas) is allowed to directly or indirectly flow from one component to another.

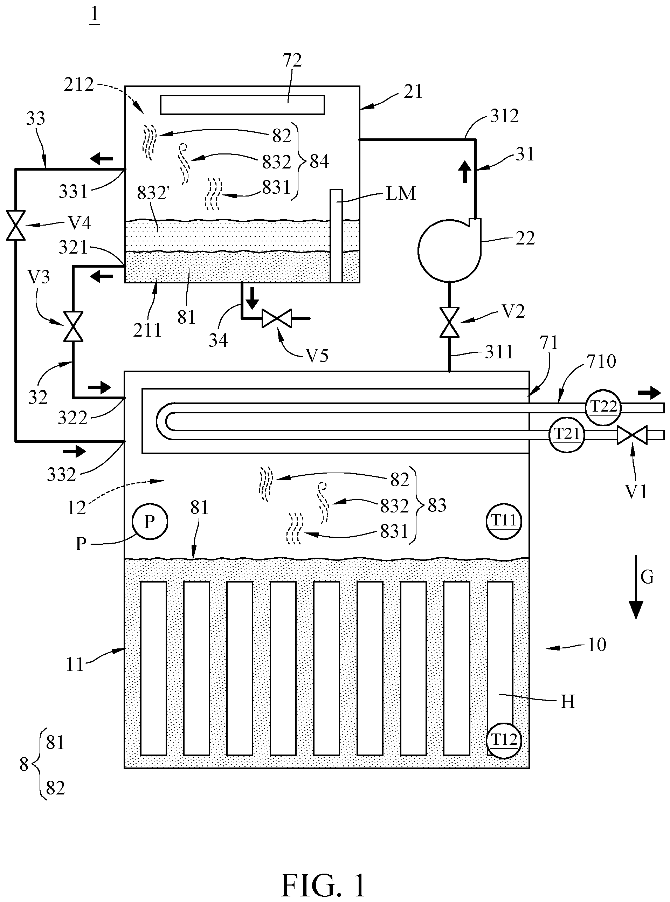

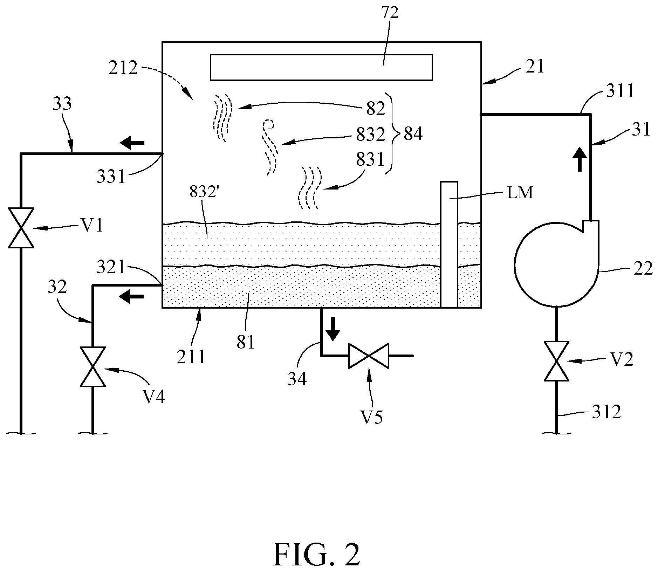

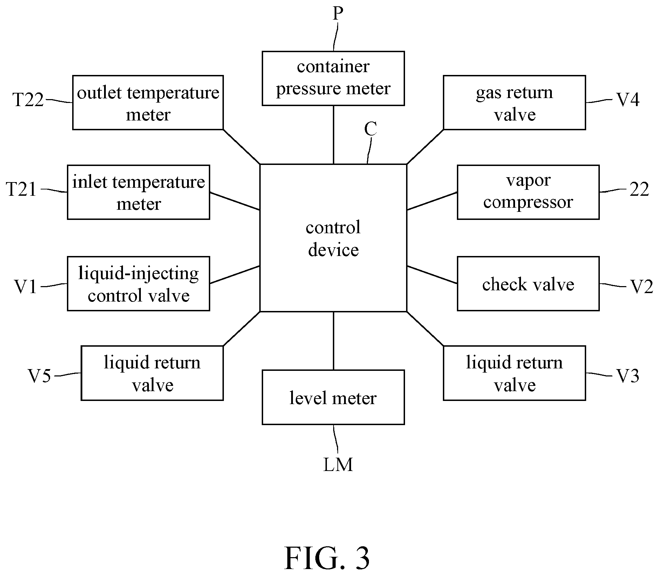

Referring to FIG. 1-3, one embodiment of the disclosure provides a two-phase immersion-cooling system **1,** the two-phase immersion-cooling system **1** may include a container **10.** The internal space of the container **10** may include a liquid-storing area **11** and a vapor area **12.** In normal use, the vapor area **12** is located at the top of the liquid-storing area **11** in the direction of gravity **G;** in other words, the liquid-storing area **11** is located below the vapor area **12** in the direction of gravity **G.**

In this embodiment, the container **10** is able to accommodate one or more heat sources **H;** specifically, the container **10** accommodate the heat source **H** in its liquid-storing area **11.** The heat source H may be, but is not limited to, one or more mainboards and/or other electronic/electrical components or devices. Note that the disclosure is not limited by the heat source **H,** its configurations, number, size, and arrangement, and the components disposed thereon.

In this embodiment, the container **10** may accommodate a two-phase coolant **8,** the two-phase coolant **8** may be, but is not limited to, a dielectric fluid having a desired low boiling point and insulation. For example, 3M^{™} Fluorinert^{™} Electronic Liquid FC-3284 may be implemented as the two-phase coolant **8** in one the embodiment of the disclosure. In some embodiments, the desired low boiling point of the two-phase coolant **8** may be at least be lower than the working temperature of the heat source **H** (e.g., approximately ranging between 40 and 60 Celsius degrees). Therefore, the two-phase coolant **8** is suitable for being in direct thermal contact with the heat source **H** for effectively and directly absorbing heat generated by the heat source **H.** Herein, a liquid-phase coolant **81** is referred to a state of the two-phase coolant **8** when staying liquid, and the gas-phase coolant **82** is referred to a state of the two-phase coolant **8** when vaporizing. In more detail, before the two-phase coolant **8** reaches a certain temperature, the two-phase coolant **8** stays in a state of liquid-phase coolant **81;** as the two-phase coolant **8** reaches a certain temperature, the liquid-phase coolant **81** is vaporized to a gas-phase coolant **82;** when the temperature of the gas-phase coolant **82** decreases to a certain temperature, the gas-phase coolant **82** is condensing into the liquid-phase coolant **81.** It is noted that the disclosure is not limited by the two-phase coolant **8** and its type and physical properties.

In this embodiment, the liquid-phase coolant **81** may be accommodated in the liquid-storing area **11** of the container **10** so that the liquid-phase coolant **81** can be in direct thermal contact with the heat source **H** and is able to effectively absorb heat generated by the heat source **H.** Specifically, at least part of the heat source **H** or whole of the heat source **H** may be immersed into the liquid-phase coolant **81** to cause the phase transition of the two-phase coolant **8** from the liquid-phase coolant **81** to the gas-phase coolant **82.**

While the liquid-phase coolant **81** is changing to the gas-phase coolant **82,** the gas-phase coolant **82** flows towards the vapor area **12** of the container **10** in a direction opposite to the direction of gravity **G.** The gas-phase coolant **82** entering into the vapor area **12** may be mixed with air **831** and water vapor **832** which already exist in the vapor area **12.** As shown, a mixed gas **83** is referred to the mixture of the gas-phase coolant **82,** the air **831,** and the water vapor **832.** It is noted that the air **831** means the gaseous substances whose composition is different from the two-phase coolant **8** and water (H₂O), and the water vapor **832** refers to the gaseous form of water.

Optionally, the cooling system **1** may further include a control device **C.** The control device **C** may be, but is not limited to be, disposed on the container **10** of the cooling system **1** or other suitable solid structure. The control device **C** may be electrically connected to some of devices of the cooling system **1** that will be described in following paragraphs by a wired or wireless manner. As such, the control device **C** is able to receive singles from the devices of the cooling system **1** and instruct them to perform predetermined functions.

Optionally, the cooling system **1** may further include a first container temperature sensor **T11.** Any suitable temperature sensor may be employed as the first container temperature sensor **T11.** In some embodiments, the first container temperature sensor **T11** is allowed to have signal communication with the control device **C** by a wired or wireless manner. In some embodiments, the first container temperature sensor **T11** may be arranged in the vapor area **12** of the container **10** to measure the temperature of the mixed gas **83** in the vapor area **12.**

Optionally, the cooling system **1** may further include a second container temperature sensor **T12.** Any suitable temperature sensor may be employed as the second container temperature sensor **T12.** In some embodiments, the second container temperature sensor **T12** is allowed to have signal communication with the control device **C** by a wired or wireless manner. In some embodiments, the second container temperature sensor **T12** may be arranged in the liquid-storing area **11** of the container **10** to measure the temperature of the liquid-phase coolant **81** in the liquid-storing area **11.**

Optionally, the cooling system **1** may further include at least one container pressure sensor **P.** Any suitable pressure sensor may be employed as the container pressure sensor **P.** In some embodiments, the container pressure sensor **P** is allowed to have signal communication with the control device **C** by a wired or wireless manner. In some embodiments, the container pressure sensor **P** may be arranged in the vapor area **12** of the container **10** to measure the pressure of the vapor area **12.**

Optionally, the cooling system **1** may further include at least one condenser **71.** Any suitable condenser may be employed as the condenser **71.** The condenser **71** may be arranged in the vapor area **12** of the container **10** to condense the gas-phase coolant **82** in the vapor area **12** into the liquid-phase coolant **81.** The condensed liquid-phase coolant **81** will fall back to the liquid-storing area **11** due to gravity. Note that the higher portion of the gas-phase coolant **82** is in the mixed gas **83,** the faster the condenser **71** condenses the gas-phase coolant **82** into the liquid-phase coolant **81.**

In this embodiment, the condenser **71** may include a cooling water channel **710.** At least part of the cooling water channel **710** is arranged in the vapor area **12.** The cooling water channel **710** is configured to guide external water (not shown) to flow through the vapor area **12** so as to cool the gas-phase coolant **82** in the vapor area **12.**

Optionally, the cooling system **1** may further include a liquid-injecting control valve **V1.** The liquid-injecting control valve **V1** may be disposed on the cooling water channel **710.** Specifically, the liquid-injecting control valve **V1** may be disposed adjacent to the inlet of the cooling water channel **710.** The liquid-injecting control valve **V1** may be opened or closed at a specific point of time for the purpose of regulating the flowrate of the fluid that the cooling water channel **710** inject into the vapor area **12.** In some embodiments, the liquid-injecting control valve **V1** is allowed to have signal communication with the control device **C** by a wired or wireless manner, so that the control device **C** is able to adjust the valve opening of the liquid-injecting control valve **V1.**

Optionally, the cooling system **1** may further include an inlet temperature sensor **T21** and an outlet temperature sensor **T22.** Any suitable pressure sensor may be employed as the inlet temperature sensor **T21** and the outlet temperature sensor **T22.** The inlet temperature sensor **T21** and the outlet temperature sensor **T22** may be respectively arranged adjacent to the inlet and outlet of the cooling water channel **710,** thus the inlet temperature sensor **T21** and the outlet temperature sensor **T22** are respectively able to measure the temperature of the fluid that the cooling water channel **710** inject into the vapor area **12** and the temperature of the fluid that the cooling water channel **710** discharge out of the vapor area **12.** In some embodiments, the inlet temperature sensor **T21** and the outlet temperature sensor **T22** are allowed to have signal communication with the control device **C** by a wired or wireless manner.

In this embodiment, the cooling system **1** may further include a pressure vessel **21,** a vapor compressor **22,** and a gas channel **31.** The gas channel **31** may be connected between the pressure vessel **21** and the container **10.** The pressure vessel **21** may be disposed on the gas channel **31.** Herein, the internal space of the pressure vessel **21** may include a liquid-collecting area **211** and a gas-collecting area **212.** In normal use, the liquid-collecting area **211** is located below the gas-collecting area **212** in the direction of gravity **G.**

As shown, the gas channel **31** may have a gas inlet **311** and a gas outlet **312,** the vapor compressor **22** is selectively in fluid communication with the gas inlet **311** and the gas outlet **312.** In specific, the vapor compressor **22** is selectively in fluid communication with the container **10** via the gas inlet **311,** the vapor compressor **22** is selectively in fluid communication with the pressure vessel **21** via the gas outlet **312.** More specifically, the vapor compressor **22** is selectively in fluid communication with the vapor area **12** of the container **10** via the gas inlet **311,** the vapor compressor **22** is selectively in fluid communication with the gas-collecting area **212** of the pressure vessel **21** via the gas outlet **312.** Any suitable vapor compressor may be employed as the vapor compressor **22.** The vapor compressor **22** is able to draw the mixed gas **83** out of the vapor area **12** of the container **10** via the gas inlet **311** and to pressurize the drawn mixed gas **83** into a high pressure mixed gas **84,** and then the high pressure mixed gas **84** is injected into the gas-collecting area **212** of the pressure vessel **21** via the gas outlet **312.** In some embodiments, the vapor compressor **22** is allowed to have signal communication with the control device **C** by a wired or wireless manner, thus the vapor compressor **22** may be turned on or turned off by the control device **C** as required.

Optionally, the cooling system **1** may further include a check valve **V2.** The check valve **V2** may be disposed adjacent to the gas inlet **311** of the gas channel **31** for the purpose of preventing the drawn mixed gas **83** by the vapor compressor **22** from flowing back to the container **10** through the gas channel **31.** In some embodiments, the check valve **V2** is allowed to have signal communication with the control device **C** by a wired or wireless manner and therefore is operable by the control device **C.**

Optionally, the cooling system **1** may further include a cooling unit **72.** Any suitable device that help cool ambient temperature may be employed as the cooling unit **72.** The cooling unit **72** may be arranged in the pressure vessel **21** to cool the internal temperature of the pressure vessel **21.** Specifically, the cooling unit **72** may be arranged in the gas-collecting area **212** of the pressure vessel **21** and therefore is able to condense the water vapor **832** within the gas-collecting area **212** into water **832'** and to condense the gas-phase coolant **82** into the liquid-phase coolant **81,** and the condensed water **832'** and the liquid-phase coolant **81** will fall into the liquid-collecting area **211.** It is noted that the water **832'** and the liquid-phase coolant **81** are incompatible with each other and are different in density, thus, the water **832'** and the liquid-phase coolant **81** will be layered in the liquid-collecting area **211.** For example, as shown, the water **832'** will layer on the top of the liquid-phase coolant **81.** In addition, since the mixed gas **83** in the container **10** is drawn into the pressure vessel **21** and pressurized into the high pressure mixed gas **84** by the vapor compressor **22,** the gas-phase coolant **82** in the high pressure mixed gas **84** is much easier to be condensed into the liquid-phase coolant **81.**

Optionally, the cooling system **1** may further include a level gauge **LM.** Any suitable liquid level sensing device may be employed as the level gauge **LM.** The level gauge **LM** may be arranged in the liquid-collecting area **211** of the pressure vessel **21** and configured to measure or determine whether one or more than two different liquids exist at particular levels in a container. In specific, the lever sensor **LM** is able to determine if the water **832'** exists at a particular level in the pressure vessel **21** and, meanwhile, the lever sensor **LM** is also able to determine if the liquid-phase coolant **81** exists at a particular level in the pressure vessel **21.** In some embodiments, the level gauge **LM** is allowed to have signal communication with the control device **C** by a wired or wireless manner. In some other embodiments, there may be two level gauges LM respectively used to measure or determine the levels of water and liquid-phase coolant.

Optionally, the cooling system **1** may further include a liquid-returning channel **32.** The liquid-returning channel **32** may be connected between the pressure vessel **21** and the container **10.** As shown, the liquid-returning channel **32** and the gas channel **31** may be respectively connected to different sides of the container **10.** Specifically, the liquid-returning channel **32** may have a liquid inlet **321** and a liquid outlet **322** respectively located at two opposite ends of the liquid-returning channel **32.** The liquid inlet **321** and the liquid outlet **322** are selectively in fluid communication with the liquid-collecting area **211** of the pressure vessel **21** and the vapor area **12** of the container **10,** respectively. Thus, the liquid-phase coolant **81** collected in the liquid-collecting area **211** is allowed to flow back to the vapor area **12** of the container **10** via the liquid-returning channel **32** as required.

Optionally, the cooling system **1** may further include a liquid return valve **V3,** The liquid return valve **V3** may be disposed on the liquid-returning channel **32.** In some embodiments, the liquid return valve **V3** is allowed to have signal communication with the control device **C** by a wired or wireless manner and therefore is operable by the control device **C.** Thus, the liquid return valve **V3** may be opened at a specific point of time to let the liquid-phase coolant **81** flow back to the vapor area **12** of the container **10** from the liquid-collecting area **211.** When the liquid-phase coolant **81** returns to the vapor area **12** via the liquid-returning channel **32,** the liquid-phase coolant **81** will fall back to the liquid-storing area **11** of the container **10.**

Optionally, the cooling system **1** may further include a gas-returning channel **33.** The gas-returning channel **33** may be connected between the pressure vessel **21** and the container **10.** Specifically, the gas-returning channel **33** may have a gas inlet **331** and a gas outlet **332** respectively located at two opposite ends of the gas-returning channel **33.** The gas inlet **331** and the gas outlet **332** are selectively in fluid communication with the gas-collecting area **212** of the pressure vessel **21** and the vapor area **12** of the container **10,** respectively. Thus, the high pressure mixed gas **84** in the gas-collecting area **212** is allowed to flow back to the vapor area **12** of the container **10** via the gas-returning channel **33** as required.

Optionally, the cooling system **1** may further include a gas return valve **V4.** The gas return valve **V4** may be disposed on the gas-returning channel **33.** In some embodiments, the gas return valve **V4** is allowed to have signal communication with the control device **C** by a wired or wireless manner and therefore is operable by the control device **C.** The gas return valve **V4** is selectively opened to allow the high pressure mixed gas **84** in the gas-collecting area **212** to flow towards the vapor area **12** of the container **10** through the gas-returning channel **33.**

Optionally, the cooling system **1** may further include a drainage channel **34.** The drainage channel **34** may be connected to the bottom of the pressure vessel **21** and is selectively in fluid communication with the liquid-collecting area **211.** The cooling system **1** may further include a liquid return valve **V5,** the liquid return valve **V5** may be disposed on the drainage channel **34.** In some embodiments, the liquid return valve **V5** is allowed to have signal communication with the control device **C** by a wired or wireless manner and therefore is operable by the control device **C.** The liquid return valve **V5** is selectively opened to allow the liquid substance to flow out of the liquid-collecting area **211** via the drainage channel **34.**

As such, the vapor compressor **22** is able to draw the mixed gas **83** from the container **10** and raise the pressure of the mixed gas **83** and pump it into the pressure vessel **21** and thus making it become the high pressure mixed gas **84.** By doing so, the pressure vessel **21** may reach a high internal pressure of making the gas-phase coolant **82** condensed easier but keeping the air **831** in gas form. Thus, the gas-phase coolant **82** in the pressure vessel **21** will be condensed into the liquid-phase coolant **81** and fall to the liquid-collecting area **211.** As a result, the two-phase coolant **8** can be separated from the high pressure mixed gas **84.** Then, the liquid-phase coolant **81** is allowed to flow back to the vapor area **12** of the container **10** via the liquid-returning channel **32,** selectively, and thereby helping maintain or increase the amount of the gas-phase coolant **82** in the container **10.** Consequently, in the vapor area **12** of the container **10,** the proportion of the gas-phase coolant **82** to the air **831** can be increased or maintained at a certain level, thereby making the condensation of the gas-phase coolant **82** into the liquid-phase coolant **81** done by the condenser **71** become much more efficient.

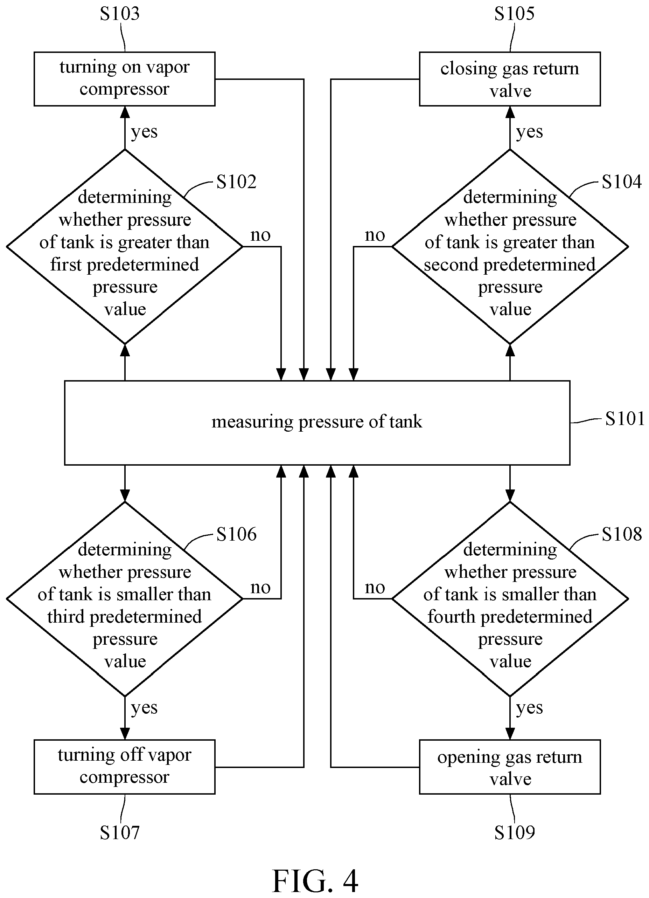

Then, a vapor pressure controlling method for the cooling system **1** will be described with further reference to FIGS. 4-6. Firstly, during the operation of the heat sources **H,** the liquid-phase coolant **81** in the liquid-storing area **11** of the container **10** continuously absorbs the heat generated by the heat source **H** and therefore turns into the gas-phase coolant **82.** The gas-phase coolant **82** flow towards the vapor area **12** of the container **10** and therefore is fixed with the air **831** and the water vapor **832** that exist in the vapor area **12.** The gas-phase coolant **82,** the air **831,** and the water vapor **832** are mixed into a mixed gas **83,** and the coolant (not shown) passing through the cooling water channel **710** of the condenser **71** is able to condense the gas-phase coolant **82** back to the liquid-phase coolant **81.**

During the above transition, in FIG. 4, the cooling system **1** may perform step **S101** to measure the pressure of the container **10.** Specifically, in step **S101,** the container pressure sensor **P** disposed in the vapor area **12** of the container **10** is able to measure the pressure of the vapor area **12** and transmits the pressure value to the control device **C.**

Then, the cooling system **1** may perform step **S102** to determine whether the pressure of the container **10** is greater than a first predetermined pressure value. Specifically, in step **S102,** when the control device **C** determines that the pressure of the vapor area **12** of the container **10** is greater than the first predetermined pressure value using the container pressure sensor **P,** which means that the internal pressure of the container **10** or the pressure difference between the internal of the container **10** and the outside may reach or exceed a level that can cause damage to the container **10** and therefore leads to leakage of the two-phase coolant **8.** Thus, the cooling system 1 performs step **S103** to activate the vapor compressor **22.** It is noted that the actual value of the first predetermined pressure value may be modified as required and is not intended to limit the disclosure.

As discussed, when the vapor compressor **22** is activated, the mixed gas **83** in the vapor area **12** will be pumped into the gas-collecting area **212** of the pressure vessel **21** and pressurized to become a high pressure mixed gas **84.** During the operation of the vapor compressor **22,** the pressure of the vapor area **12** of the container **10** is dropping due to the gradual removal of the mixed gas **83,** thereby helping prevent damage to the contain **10** and coolant leakage due to the high internal pressure of the container **10** or the high pressure difference between the internal of the container **10** and the outside. Meanwhile, the internal pressure of the pressure vessel **21** is increased by the vapor compressor **22.** Specifically, the internal pressure of the pressure vessel **21** may reach a level that makes gas-phase coolant **82** condensed easier by the cooling unit **72** but keeps the air **831** remaining in gas form. As such, the liquid-phase coolant **81** will be separated from the high pressure mixed gas **84,** and the rest substances in the high pressure mixed gas **84,** such as air **831** and at least part of the water vapor **832,** will be remaining in the gas-collecting area **212** of the pressure vessel **21.** The gas-phase coolant **82** is condensing into the liquid-phase coolant **81** and falling to the liquid-collecting area **211** of the pressure vessel **21,** and a portion of the water vapor **832** may be condensed into water **832'** and collected in the liquid-collecting area **211.** The water **832'** and the liquid-phase coolant **81** are incompatible with each other and therefore will be layered in the liquid-collecting area **211.**

When the step **S102** determines that the pressure of the container **10** is not greater than the first predetermined pressure value, which means that the internal pressure of the container **10** or the pressure difference between the internal of the container **10** and the outside does not reach or exceed the level that can causes damage to the container **10** and leakage of the two-phase coolant **8,** thus the cooling system **1** keeps performing the step **S101** to measure the pressure of the container **10.**

Meanwhile or then, the cooling system 1 may perform step **S104** to determine whether the pressure of the container **10** is greater than a second predetermined pressure value. Specifically, the pressure of the vapor area **12** of the container **10** may go up and down due to the continuous evaporation of the liquid-phase coolant **81** and/or the flowing of the mixed gas **83** to the pressure vessel **21,** to prevent the internal pressure of the container **10** or the pressure difference between the internal of the container **10** and the outside from becoming too high, the cooling system 1 can perform step **S105** to close the gas return valve **V4.** When the gas return valve **V4** is closed, the high pressure mixed gas **84** in the gas-collecting area **212** of the pressure vessel **21** is stopped from flowing into the vapor area **12** of the container **10** via the gas-returning channel **33,** thus the high pressure mixed gas **84** is prevented from increasing the internal pressure of the container **10** or the pressure difference between the internal of the container **10** and the outside. Then, the cooling system **1** can perform step **S101** to keep measuring the pressure of the container **10.** It is noted that the actual value of the second predetermined pressure value may be modified as required and is not intended to limit the disclosure.

When the step **S104** determines that the pressure of the container **10** is not larger than the second predetermined pressure value, which means that the internal pressure of the container **10** or the pressure difference between the internal of the container **10** and the outside does not reach or exceed the level that can causes damage to the container **10** and leakage of the two-phase coolant **8,** thus the cooling system **1** keeps performing the step **S101** to measure the pressure of the container **10.**

Meanwhile or then, the cooling system **1** may perform step **S106** to determine whether the pressure of the container **10** is smaller than a third predetermined pressure value. Specifically, in step **S106,** when the control device **C** determines that the pressure of the vapor area **12** of the container **10** is relatively low using the container pressure sensor **P,** the internal pressure of the container **10** or the pressure difference between the internal of the container **10** and the outside may not yet high enough to cause damage to the container **10,** but it may decrease the partial pressure of the gas-phase coolant **82** in the mixed gas **83** and thereby affecting the transition from the gas-phase coolant **82** to the liquid-phase coolant **81.** Thus, the cooling system **1** performs step **S107** to turn off the vapor compressor **22,** such that the pressure drop of the container **10** due to the flowing of the mixed gas **83** into the pressure vessel **21** is stopped. By doing so, in the vapor area **12** of the container **10,** the partial pressure of the gas-phase coolant **82** in the mixed gas **83** will be increased due to the continuous evaporation of the liquid-phase coolant **81.** As such, the range of temperature that can cause the transition from the gas-phase coolant **82** to the liquid-phase coolant **81** to occur become wider, thus the condenser **71** is allowed to employ a relatively wide temperature range of the coolant to condense the gas-phase coolant **82.** It is noted that the actual value of the third predetermined pressure value may be modified as required and is not intended to limit the disclosure.

When the step **S106** determines that the pressure of the container **10** is not smaller than the third predetermined pressure value, which means that the coolant provided by the condenser **71** has no need to be at a relatively low temperature but the partial pressure of the gas-phase coolant **82** in the mixed gas **83** is high enough to make the transition of the gas-phase coolant **82** to the liquid-phase coolant **81** occur. Then, the cooling system **1** keeps performing the step **S101** to measure the pressure of the container **10.**

Meanwhile or then, the cooling system **1** may perform step **S108** to determine whether the pressure of the container **10** is smaller than a fourth predetermined pressure value. Specifically, in step **S108,** when the control device **C** determines that the pressure of the vapor area **12** of the container **10** is relatively low using the container pressure sensor **P,** the internal pressure of the container **10** or the pressure difference between the internal of the container **10** and the outside may not yet high enough to cause damage to the container **10,** but it may decrease the partial pressure of the gas-phase coolant **82** in the mixed gas **83** and thus lowing the condensable temperature of the gas-phase coolant **82.** This result makes the condenser **72** to provide a lower temperature coolant, otherwise it is unable to effectively make the condensation of the gas-phase coolant **82** occur. Thus, the cooling system **1** performs step **S109** to open the gas return valve **V4** to let the high pressure mixed gas **84** in the gas-collecting area **212** of the pressure vessel **21** to flow towards the vapor area **12** of the container **10** via the gas-returning channel **33.** By doing so, the partial pressure of the gas-phase coolant **82** in the mixed gas **83** is increased and therefore the condensable temperature of the gas-phase coolant **82** is increased, ensuring that a relatively wide temperature range of coolant provided by the condenser **71** is able to effectively and efficiently condense the gas-phase coolant **82.** It is noted that the actual value of the fourth predetermined pressure value may be modified as required and is not intended to limit the disclosure.

Then, please see table 1 below, which shows the temperature/saturated vapor pressure of the two-phase coolant **8** being FC-3284. As can be seen, when the air **831** and water vapor **832** of the mixed gas **83** is drawn into the pressure vessel **21** from the vapor area **12** of the container **10,** the proportion of the gas-phase coolant **82** in the vapor area **12** of the container **10** will increase. Under the same total pressure, the partial pressure of the gas-phase coolant **82** in the container **10** will increase as well, thus the condensable temperature of the gas-phase coolant **82** in the container **10** is increased, such that the condenser **71** becomes more effectively in condensing the gas-phase coolant **82.** As a result, the condenser **71** is able to effectively condense the gas-phase coolant **82** only using a coolant in relatively high temperature and less flowrate, thus, the loading and power-consumption of the condenser **71** are significantly reduced.

**Table 1 (temperature/saturated vapor pressure of FC-3284)**

| temperature(°C) | saturated vapor pressure (KPa) |
|---|---|
| 20 | 28.66 |
| 25 | 35.59 |
| 30 | 43.87 |
| 35 | 53.72 |
| 40 | 65.36 |
| 45 | 79.02 |
| 50 | 94.95 |

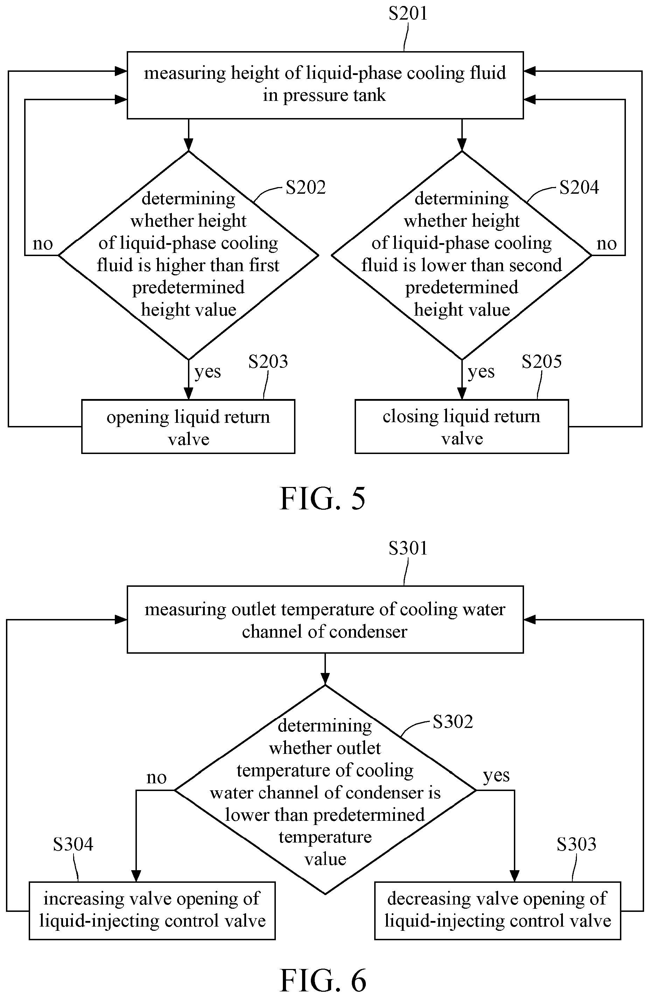

In FIG. 5, the cooling system **1** may perform **S201** to measure the level or height of the liquid-phase coolant **81** in the pressure vessel **21.** Specifically, the level gauge **LM** disposed in the liquid-collecting area **211** of the pressure vessel **21** is able to determine the height of the liquid-phase coolant **81** or determine whether the level of the liquid-phase coolant **81** reach a certain value, and transmits the measurement to the control device **C.**

Then, the cooling system **1** may perform step **S202** to determine whether the height of the liquid-phase coolant **81** is higher than a first predetermined height value using the level gauge **LM.** Specifically, in step **S202,** when the control device **C** determines that the height of the liquid-phase coolant **81** in the liquid-collecting area **211** of the pressure vessel **21** is higher than the first predetermined height value using the level gauge **LM,** which means that the liquid-phase coolant **81** in the pressure vessel **21** is excessive; that is, the pressure vessel **21** takes too much gas-phase coolant **82** from the container **10** and thereby will affect the cooling efficiency. Thus, the cooling system **1** perform step **S203** to open the liquid return valve **V3.** When the liquid return valve **V3** is opened, the liquid-phase coolant **81** in the liquid-collecting area **211** of the pressure vessel **21** is allowed to flow into the vapor area **12** of the container **10** via the liquid-returning channel **32** and then to fall back to the liquid-storing area **11** of the container **10,** thereby achieving collection of the two-phase coolant **8.** It is noted that the actual value of the first predetermined height value may be modified as required and is not intended to limit the disclosure.

When the step **S201** determines that the height of the liquid-phase coolant **81** in the liquid-collecting area **211** of the pressure vessel **21** is not higher than the first predetermined height value, the cooling system **1** keeps performing **S201** to detect the liquid level of the liquid-phase coolant **81.**

Meanwhile or then, the cooling system **1** may perform step **S204** to determine whether the height of the liquid-phase coolant **81** is lower than a second predetermined height value using the level gauge **LM.** Specifically, in step **S204,** when the control device **C** determines that the height of the liquid-phase coolant **81** in the liquid-collecting area **211** of the pressure vessel **21** is lower than the second predetermined height value using the level gauge **LM,** which means that the pressure vessel **21** may inject too much liquid-phase coolant **81** into the container **10.** In one case, it may mean that there is no liquid-phase coolant **81** left in the pressure vessel **21.** At that moment, the cooling system **1** may perform step **S205** to close the liquid return valve **V3.** When the liquid return valve **V3** is closed, the liquid substance in the pressure vessel **21** is stopped from flowing towards the container **10.** By doing so, the water **832'** in the pressure vessel **21** is prevented from sending to the container **10.** It is noted that the actual value of the second predetermined height value may be modified as required and is not intended to limit the disclosure.

When the step **S204** determines that the height of the liquid-phase coolant **81** in the liquid-collecting area **211** of the pressure vessel **21** is not lower than the second predetermined height value, the cooling system **1** keeps performing **S201** to detect the liquid level of the liquid-phase coolant **81.**

In FIG. 6, the cooling system **1** may perform **S301** to measure the outlet temperature of the cooling water channel **710** of the condenser **71.** Specifically, the outlet temperature sensor **T22** disposed at the outlet of the cooling water channel **710** of the condenser **71** is able to measure the outlet temperature of the cooling water channel **710** and transmits the measurement to the control device **C.**

Then, the cooling system **1** may perform step **S302** to determine whether the outlet temperature of the cooling water channel **710** of the condenser **71** is lower than a predetermined temperature value. Specifically, in step **S302,** when the control device **C** determines that the outlet temperature of the cooling water channel **710** is lower than the predetermined temperature value using the outlet temperature sensor **T22,** which means that the coolant provided by the condenser **71** for cooling the container **10** may be excessive. Thus, the cooling system **1** may perform step **S303** to decrease the valve opening of the liquid-injecting control valve **V1.** Specifically, when the control device **C** instructs the liquid-injecting control valve **V1** to decrease its valve opening, the flowrate of the coolant provided by the condenser **71** to the vapor area **12** of the container **10** is decreased, thereby achieving a balance between the flowrate of coolant and condensing the liquid-phase coolant **81.**

When the control device **C** determines that the outlet temperature of the cooling water channel **710** is not lower than the predetermined temperature value using the outlet temperature sensor **T22,** which means that the coolant provided by the condenser **71** may be insufficient to efficiently condense the liquid-phase coolant **81** in the container **10.** Thus, the cooling system **1** performs step **S304** to increase the valve opening of the liquid-injecting control valve **V1** so as to increase the flowrate of the coolant that the condenser **71** provides to the vapor area **12** of the container **10.** By doing so, the liquid-phase coolant **81** will be condensed in a manner as required. It is noted that the actual value of the predetermined temperature value may be modified as required and is not intended to limit the disclosure.

As discussed, since the vapor compressor is able to draw the gas substance from the container and inject it to the pressure vessel, the internal pressure of the container can be prevented from being too high to cause damage to the container, and leakage due to high pressure difference between the internal of the container and the outside is effectively prevented.

Also, the air and water vapor in the vapor area of the container can be selectively moved to the pressure vessel, thus the proportion of the gas-phase coolant in the vapor area of the container can be increased. As such, under the same total pressure, the partial pressure of the gas-phase coolant in the container will be increased, thus the condensable temperature of the gas-phase coolant in the container can be increased, such that the condenser being arranged in the vapor area of the container is able to effectively condense the gas-phase coolant only using a coolant in relatively high temperature and less flowrate, thus, the loading and power-consumption of the condenser are significantly reduced.

In addition, the gas-phase coolant is pressurized and pumped to the pressure vessel from the container, the internal pressure of the pressure vessel may reach a level that makes the gas-phase coolant from the container condensed easier but keeps the air remaining in gas form, thus air and water vapor will be remaining in the gas-collecting area of the pressure vessel and the gas-phase coolant will be condensed and falling to the liquid-collecting area of the pressure vessel, thereby preventing loss of the two-phase coolant during heat dissipation. As required, the liquid-phase coolant in the liquid-collecting area is allowed to flow back to the container via the liquid-returning channel.

Further, since higher pressure makes the gas-phase coolant of the two-phase coolant condensed easier, the cooling unit being arranged in the pressure vessel is also allowed to employ a relatively wide temperature range of the coolant to condense the gas-phase coolant of the two-phase coolant, such that a balance between power-consumption and cooling efficiency is achieved and thereby helping improve the power usage effectiveness (PUE) of the system.

In short, according to the two-phase immersion-cooling system and the vapor pressure controlling method as discussed in the above embodiments of the disclosure, it is possible to automatically reduce the pressure of the container and prevent damage to the contain and coolant leakage due to the high internal pressure of the container or the high pressure difference between the internal of the container and the outside. The partial pressure of the gas-phase coolant can be automatically increased to make the condenser more effective in condensation, and the gas substance in the pressure vessel can be automatically feed back to the contain according to the partial pressure of the gas-phase coolant in the container. As such, the two-phase coolant is effectively prevented from leaking while significantly reducing the loading and power-consumption of the condenser.

It will be apparent to those skilled in the art that various modifications and variations can be made to the present disclosure. It is intended that the specification and examples be considered as exemplary embodiments only, with a scope of the disclosure being indicated by the following claims.

## Claims

1. A vapor pressure controlling method for controlling a two-phase immersion-cooling system (1),
whereby the two-phase immersion-cooling system comprises a container (10), a pressure vessel (21) connected to a vapor area of the container via a gas channel (31), and a vapor compressor (22) disposed on the gas channel, the vapor pressure controlling method comprises:
measuring a pressure of the container; and
determining whether the pressure of the container is greater than a first predetermined pressure value;
when the pressure of the container is determined to be greater than the first predetermined pressure value, the vapor compressor is activated to draw a mixed gas (83) in the vapor area of the container so as to decrease pressure of the vapor area and inject the mixed gas into the pressure vessel so as to increase pressure of the pressure vessel; and
when the pressure of the container is determined to be not greater than the first predetermined pressure value, the step of measuring the pressure of the container is performed;
**characterised in that** the vapor pressure controlling method further comprises:
determining whether the pressure of the container is smaller than a third predetermined pressure value;
when the pressure of the container is determined to be smaller than the third predetermined pressure value, the vapor compressor is turned off; and
when the pressure of the container is determined to be not smaller than the third predetermined pressure value, the step of measuring the pressure of the container is performed.

2. The vapor pressure controlling method according to claim 1, further comprising:
determining whether the pressure of the container is greater than a second predetermined pressure value;
when the pressure of the container is determined to be greater than the second predetermined pressure value, a gas return valve (V4) disposed on a gas-returning channel (33) between a gas-collecting area (212) of the pressure vessel and the vapor area of the container is closed; and
when the pressure of the container is determined to be not greater than the second predetermined pressure value, the step of measuring the pressure of the container is performed.

3. The vapor pressure controlling method according to claim 1, further comprising:
determining whether the pressure of the container is smaller than a fourth predetermined pressure value;
when the pressure of the container is determined to be smaller than the fourth predetermined pressure value, a gas return valve (V4) disposed on a gas-returning channel (33) between a gas-collecting area (212) of the pressure vessel and the vapor area of the container is opened; and
when the pressure of the container is determined to be not smaller than the fourth predetermined pressure value, the step of measuring the pressure of the container is performed.

4. The vapor pressure controlling method according to claim 1, further comprising:
measuring a height of a liquid-phase coolant in a liquid-collecting area (211) of the pressure vessel;
determining whether the height of the liquid-phase coolant in the pressure vessel is higher than a first predetermined height value;
when the height of the liquid-phase coolant in the pressure vessel is determined to be higher than the first predetermined height value, a liquid return valve (V3) disposed on a liquid-returning channel (32) between the liquid-collecting area of the pressure vessel and the vapor area of the container is opened; and
when the height of the liquid-phase coolant in the pressure vessel is determined to be not higher than the first predetermined height value, the step of measuring the height of the liquid-phase coolant in the liquid-collecting area of the pressure vessel is performed.

5. The vapor pressure controlling method according to claim 1, further comprising:
measuring a height of a liquid-phase coolant (81) in a liquid-collecting area (211) of the pressure vessel;
determining whether the height of the liquid-phase coolant in the pressure vessel is lower than a second predetermined height value;
when the height of the liquid-phase coolant in the pressure vessel is determined to be lower than the second predetermined height value, a liquid return valve (V3) disposed on a liquid-returning channel (32) between the liquid-collecting area of the pressure vessel and the vapor area of the container is closed; and
when the height of the liquid-phase coolant in the pressure vessel is determined to be not lower than the second predetermined height value, the step of measuring the height of the liquid-phase coolant in the liquid-collecting area of the pressure vessel is performed.

6. The vapor pressure controlling method according to claim 1, further comprising:
measuring an outlet temperature of a cooling water channel of a condenser (71) in the vapor area of the container;
determining whether the outlet temperature of the cooling water channel of the condenser is lower than a predetermined temperature value;
when the outlet temperature of the cooling water channel of the condenser is determined to be lower than the predetermined temperature value, a valve opening of a liquid-injecting control valve disposed on the cooling water channel is decreased; and
when the outlet temperature of the cooling water channel of the condenser is determined to be not lower than the predetermined temperature value, the valve opening of the liquid-injecting control valve disposed on the cooling water channel is increased.

## Patentansprüche

1. Dampfdruckregelungsverfahren zur Regelung eines Zweiphasen-Tauchkühlsystems (1),
wobei
das Zweiphasen-Tauchkühlsystem einen Behälter (10), ein Druckgefäß (21), das über einen Gaskanal (31) mit einem Dampfbereich des Behälters verbunden ist, und einen Dampfkompressor (22) aufweist, der an dem Gaskanal angeordnet ist, wobei das Dampfdruckregelungsverfahren aufweist:
Messen eines Drucks des Behälters; und
Feststellen, ob der Druck des Behälters größer als ein erster vorbestimmter Druckwert ist;
wenn festgestellt wird, dass der Druck des Behälters größer als der erste vorbestimmte Druckwert ist, wird der Dampfkompressor aktiviert, um ein Mischgas (83) in den Dampfbereich des Behälters zu ziehen, so dass der Druck des Dampfbereichs verringert wird und das Mischgas in das Druckgefäß eingespritzt wird, um den Druck des Druckgefäßes zu erhöhen; und
wenn festgestellt wird, dass der Druck des Behälters nicht größer als der erste vorbestimmte Druckwert ist, wird der Schritt des Messens des Drucks des Behälters durchgeführt;
**dadurch gekennzeichnet, dass**
das Dampfdruckregelungsverfahren ferner aufweist:
Feststellen, ob der Druck des Behälters kleiner als ein dritter vorbestimmter Druckwert ist;
wenn festgestellt wird, dass der Druck des Behälters kleiner als der dritte vorbestimmte Druckwert ist, wird der Dampfkompressor abgeschaltet; und
wenn festgestellt wird, dass der Druck des Behälters nicht kleiner als der dritte vorbestimmte Druckwert ist, wird der Schritt des Messens des Drucks des Behälters durchgeführt.

2. Dampfdruckregelungsverfahren nach Anspruch **1,** das ferner aufweist:
Feststellen, ob der Druck des Behälters größer als ein zweiter vorbestimmter Druckwert ist;
wenn festgestellt wird, dass der Druck des Behälters größer als der zweite vorbestimmte Druckwert ist, wird ein Gasrückführventil (V4) geschlossen, das an einem Gasrückführkanal (33) zwischen einem Gassammelbereich (212) des Druckgefäßes und dem Dampfbereich des Behälters angeordnet ist; und
wenn festgestellt wird, dass der Druck des Behälters nicht größer als der zweite vorbestimmte Druckwert ist, wird der Schritt des Messens des Drucks des Behälters durchgeführt;

3. Dampfdruckregelungsverfahren nach Anspruch 1, das ferner aufweist:
Feststellen, ob der Druck des Behälters kleiner als ein vierter vorbestimmter Druckwert ist;
wenn festgestellt wird, dass der Druck des Behälters kleiner als der vierte vorbestimmte Druckwert ist, wird ein Gasrückführventil (V4) geöffnet, das an einem Gasrückführkanal (33) zwischen einem Gassammelbereich (212) des Druckgefäßes und dem Dampfbereich des Behälters angeordnet ist; und
wenn festgestellt wird, dass der Druck des Behälters nicht kleiner als der vierte vorbestimmte Druckwert ist, wird der Schritt des Messens des Drucks des Behälters durchgeführt.

4. Dampfdruckregelungsverfahren nach Anspruch **1,** das ferner aufweist:
Messen einer Höhe eines Flüssigphasen-Kühlmittels in einem Flüssigkeitssammelbereich (211) des Druckgefäßes;
Feststellen, ob die Höhe des Flüssigphasen-Kühlmittels im Druckgefäß höher als ein erster vorbestimmter Höhenwert ist;
wenn festgestellt wird, dass die Höhe des Flüssigphasen-Kühlmittels in dem Druckgefäß höher als der erste vorbestimmte Höhenwert ist, wird ein Flüssigkeitsrücklaufventil (V3) geöffnet, das an einem Flüssigkeitsrückführkanal (32) zwischen dem Flüssigkeitssammelbereich des Druckgefäßes und dem Dampfbereich des Behälters angeordnet ist; und
wenn festgestellt wird, dass die Höhe des Flüssigphasen-Kühlmittels im Druckgefäß nicht höher als der erste vorbestimmte Höhenwert ist, wird der Schritt des Messens der Höhe des Flüssigphasen-Kühlmittels im Flüssigkeitssammelbereich des Druckgefäßes durchgeführt.

5. Dampfdruckregelungsverfahren nach Anspruch 1, das ferner aufweist:
Messen einer Höhe eines Flüssigphasen-Kühlmittels (81) in einem Flüssigkeitssammelbereich (211) des Druckgefäßes;
Feststellen, ob die Höhe des Flüssigphasen-Kühlmittels im Druckgefäß niedriger als ein zweiter vorbestimmter Höhenwert ist;
wenn festgestellt wird, dass die Höhe des Flüssigphasen-Kühlmittels in dem Druckgefäß niedriger als der zweite vorbestimmte Höhenwert ist, wird ein Flüssigkeitsrücklaufventil (V3) geschlossen, das an einem Flüssigkeitsrückführkanal (32) zwischen dem Flüssigkeitssammelbereich des Druckgefäßes und dem Dampfbereich des Behälters angeordnet ist; und
wenn festgestellt wird, dass die Höhe des Flüssigphasen-Kühlmittels im Druckgefäß nicht niedriger als der zweite vorbestimmte Höhenwert ist, wird der Schritt des Messens der Höhe des Flüssigphasen-Kühlmittels im Flüssigkeitssammelbereich des Druckgefäßes durchgeführt.

6. Dampfdruckregelungsverfahren nach Anspruch 1, das ferner aufweist:
Messen einer Austrittstemperatur eines Kühlwasserkanals eines Kondensators (71) im Dampfbereich des Behälters;
Feststellen, ob die Austrittstemperatur des Kühlwasserkanals des Kondensators niedriger als ein vorbestimmter Temperaturwert ist;
wenn festgestellt wird, dass die Austrittstemperatur des Kühlwasserkanals des Kondensators niedriger als der vorbestimmte Temperaturwert ist, wird eine Ventilöffnung eines Flüssigkeitseinspritzsteuerventils, das an dem Kühlwasserkanal angeordnet ist, verkleinert; und
wenn festgestellt wird, dass die Austrittstemperatur des Kühlwasserkanals des Kondensators nicht niedriger als der vorbestimmte Temperaturwert ist, wird die Ventilöffnung des Flüssigkeitseinspritzsteuerventils, das an dem Kühlwasserkanal angeordnet ist, vergrößert.

## Revendications

1. Procédé de régulation de pression de vapeur pour commander un système de refroidissement par immersion à deux phases (1),
selon lequel le système de refroidissement par immersion à deux phases comprend un réservoir (10), une cuve sous pression (21) raccordée à une zone de vapeur du réservoir par l'intermédiaire d'un canal de gaz (31), et un compresseur de vapeur (22) disposé sur le canal de gaz, le procédé de régulation de pression de vapeur comprend :
la mesure d'une pression du réservoir ; et
la détermination pour établir si la pression du réservoir est supérieure à une première valeur de pression prédéterminée ;
lorsque la pression du réservoir est déterminée comme étant supérieure à la première valeur de pression prédéterminée, le compresseur de vapeur est activé pour aspirer un mélange gazeux (83) dans la zone de vapeur du réservoir de manière à diminuer la pression de la zone de vapeur et injecter le mélange gazeux dans la cuve sous pression de manière à augmenter la pression de la cuve sous pression ; et
lorsque la pression du réservoir est déterminée comme étant inférieure ou égale à la première valeur de pression prédéterminée, l'étape de mesure de la pression du réservoir est effectuée ;
**caractérisé en ce que** le procédé de régulation de pression de vapeur comprend en outre :
la détermination pour établir si la pression du réservoir est inférieure à une troisième valeur de pression prédéterminée ;
lorsque la pression du réservoir est déterminée comme étant inférieure à la troisième valeur de pression prédéterminée, le compresseur de vapeur est éteint ; et
lorsque la pression du réservoir est déterminée comme étant supérieure ou égale à la troisième valeur de pression prédéterminée, l'étape de mesure de la pression du réservoir est effectuée.

2. Procédé de régulation de pression de vapeur selon la revendication 1, comprenant en outre :
la détermination pour établir si la pression du réservoir est supérieure à une deuxième valeur de pression prédéterminée ;
lorsque la pression du réservoir est déterminée comme étant supérieure à la deuxième valeur de pression prédéterminée, une soupape de retour de gaz (V4) disposée sur un canal de réinjection de gaz (33) entre une zone de collecte de gaz (212) de la cuve sous pression et la zone de vapeur du réservoir est fermée ; et
lorsque la pression du réservoir est déterminée comme étant inférieure ou égale à la deuxième valeur de pression prédéterminée, l'étape de mesure de la pression du réservoir est effectuée.

3. Procédé de régulation de pression de vapeur selon la revendication 1, comprenant en outre :
la détermination pour établir si la pression du réservoir est inférieure à une quatrième valeur de pression prédéterminée ;
lorsque la pression du réservoir est déterminée comme étant inférieure à la quatrième valeur de pression prédéterminée, une soupape de retour de gaz (V4) disposée sur un canal de réinjection de gaz (33) entre une zone de collecte de gaz (212) de la cuve sous pression et la zone de vapeur du réservoir est ouverte ; et
lorsque la pression du réservoir est déterminée comme étant supérieure ou égale à la quatrième valeur de pression prédéterminée, l'étape de mesure de la pression du réservoir est effectuée.

4. Procédé de régulation de pression de vapeur selon la revendication 1, comprenant en outre :
la mesure d'une hauteur d'un réfrigérant en phase liquide dans une zone de collecte de liquide (211) de la cuve sous pression ;
la détermination pour établir si la hauteur du réfrigérant en phase liquide dans la cuve sous pression est supérieure à une première valeur de hauteur prédéterminée ;
lorsque la hauteur du réfrigérant en phase liquide dans la cuve sous pression est déterminée comme étant supérieure à la première valeur de hauteur prédéterminée, une soupape de retour de liquide (V3) disposée sur un canal de réinjection de liquide (32) entre la zone de collecte de liquide de la cuve sous pression et la zone de vapeur du réservoir est ouverte ; et
lorsque la hauteur du réfrigérant en phase liquide dans la cuve sous pression est déterminée comme étant inférieure ou égale à la première valeur de hauteur prédéterminée, l'étape de mesure de la hauteur du réfrigérant en phase liquide dans la zone de collecte de liquide de la cuve sous pression est effectuée.

5. Procédé de régulation de pression de vapeur selon la revendication 1, comprenant en outre :
la mesure d'une hauteur d'un réfrigérant en phase liquide (81) dans une zone de collecte de liquide (211) de la cuve sous pression ;
la détermination pour établir si la hauteur du réfrigérant en phase liquide dans la cuve sous pression est inférieure à une seconde valeur de hauteur prédéterminée ;
lorsque la hauteur du réfrigérant en phase liquide dans la cuve sous pression est déterminée comme étant inférieure à la seconde valeur de hauteur prédéterminée, une soupape de retour de liquide (V3) disposée sur un canal de réinjection de liquide (32) entre la zone de collecte de liquide de la cuve sous pression et la zone de vapeur du réservoir est fermée ; et
lorsque la hauteur du réfrigérant en phase liquide dans la cuve sous pression est déterminée comme étant supérieure ou égale à la seconde valeur de hauteur prédéterminée, l'étape de mesure de la hauteur du réfrigérant en phase liquide dans la zone de collecte de liquide de la cuve sous pression est effectuée.

6. Procédé de régulation de pression de vapeur selon la revendication 1, comprenant en outre :
la mesure d'une température de sortie d'un canal d'eau de refroidissement d'un condenseur (71) dans la zone de vapeur du réservoir ;
la détermination pour établir si la température de sortie du canal d'eau de refroidissement du condenseur est inférieure à une valeur de température prédéterminée ;
lorsque la température de sortie du canal d'eau de refroidissement du condenseur est déterminée comme étant inférieure à la valeur de température prédéterminée, une ouverture de vanne d'une vanne de commande d'injection de liquide disposée sur le canal d'eau de refroidissement est réduite ; et
lorsque la température de sortie du canal d'eau de refroidissement du condenseur est déterminée comme étant supérieure ou égale à la valeur de température prédéterminée, l'ouverture de vanne de la vanne de commande d'injection de liquide disposée sur le canal d'eau de refroidissement est augmentée.
